# EUROPEAN PATENT APPLICATION

(11) **EP 2 351 718 A1**
(43) Date of publication of application: **03.08.2011**
(21) Application number: 09821970.2
(22) Date of filing: 15.10.2009
(51) Int. Cl.: C03C 27/12, B30B 12/00, G02F 1/13, G02F 1/1333, G09F 9/00, G09F 9/30, H01L 21/683, H01L 51/50, H05B 33/02, H05B 33/10

(54) **GLASS SUBSTRATE LAMINATED DEVICE AND METHOD FOR PRODUCING LAMINATE GLASS SUBSTRATE**

(30) Priority: 23.10.2008 JP 2008273081
(71) Applicant: Asahi Glass Company Limited, Chiyoda-ku Tokyo 100-8405 (JP)
(72) Inventor: KONDO Satoshi, Tokyo 100-8405 (JP); ITO Yasunori, Tokyo 100-8405 (JP)
(74) Representative: Müller-Boré & Partner Patentanwälte
(86) International application number: PCT/JP2009/067870
(87) International publication number: WO 2010/047273

(57) **Abstract**

The present invention relates to a glass substrate lamination device for laminating two glass substrates, which includes: an upper substrate supporting unit configured to absorb and support an upper glass substrate; a lower substrate supporting unit configured to mount and support a lower glass substrate; a seal unit configured to make a space between the upper substrate supporting unit and the lower substrate supporting unit into an air tight state; and a decompression unit configured to decompress the space surrounded by the upper substrate supporting unit, the lower substrate supporting unit and the seal unit; in which the upper substrate supporting unit has, on a lower surface thereof, a substrate adsorption unit having any one of shapes of the following (A), (B) and (C): (A) a substrate adsorption unit having a rectangular frame shape, (B) a substrate adsorption unit having a shape including a rectangular frame and a straight line or curved line which connects each of facing one pair or two pairs of sides among four sides constituting the rectangle of the rectangular flame, and (C) a substrate adsorption unit having a shape including a plurality of mutually crossing straight lines or curved lines.

## Description

### TECHNICAL FIELD

The present invention relates to a glass substrate lamination device and a method for producing a laminated glass substrate.

### BACKGROUND ART

In the field of a liquid crystal display (LCD), an organic EL display (OLED) and particularly a portable display such as a mobile or cellular phone, lightening and slimization of displays are becoming an important problem.
In order to correspond to this problem, it is desirable to further reduce the thickness of the glass substrate to be used in the display. As the method for reducing the thickness, there is generally used a method in which, before forming or after forming a member for display device on a glass substrate, the glass substrate is subjected to an etching treatment using hydrofluoric acid or the like and, according to the necessity, further reducing the thickness by carrying out a physical polishing.

However, when the glass substrate is thinned by carrying out an etching treatment or the like before forming the member for display device on the surface of the glass substrate, strength of the glass substrate is lowered and quantity of deflection also becomes large. Accordingly, there is a problem in that the treatment cannot be carried out by the existing production line.
In addition, when the glass substrate is thinned by carrying out an etching treatment or the like after forming the member for display device on the surface of the glass substrate, there is a problem in that fine scratches formed on the surface of the glass substrate are actualized during the step of forming the member for display device on the surface of the glass substrate, namely a problem of generation of etch pit.

Accordingly, with the aim of solving such a problem, there has been proposed a method in which a glass substrate having a thin thickness (to be referred also to as "thin glass substrate" hereinafter) is adhered to other supporting glass substrate to make a laminate, a predetermined treatment for producing a display panel is carried out under such a state, and then the thin glass substrate and supporting glass substrate are separated, and the like.

For example, Patent Documents 1 discloses a thin glass laminate in which a thin glass substrate and a supporting glass substrate are laminated and the thin glass substrate and the supporting glass substrate are laminated via a silicone resin layer having easily separable property and non pressure-sensitive adhesiveness. In addition, it is described that such a glass laminate can be produced by adhesion under a pressure using a roller or press or employing a vacuum lamination method or vacuum press method.

### BACKGROUND ART DOCUMENT

### Patent Documents

Patent Document 1: International Publication No. 2007/018028

### SUMMARY OF THE INVENTION

### PROBLEMS THAT THE INVENTION IS TO SOLVE

In the case of forming the glass laminate described in Patent Reference 1, generally, there can be employed a vacuum lamination press method, namely a method in which a supporting glass substrate and a thin glass substrate are set to a compressor under a temporarily laminated state via a resin layer, vacuumed and then pressed.
However, even when pressed, it causes a problem in that bubbles between the thin glass substrate and resin layer are remained and cannot be removed completely. This becomes notable particularly when size of the thin glass substrate is large.

As a countermeasure for this, for example, there can be considered a method in which a thin glass substrate is adsorbed to the upper pressurization unit and kept thereto, a gap is kept between a supporting glass substrate and the thin glass substrate, the spaces possessed by both substrates are made vacuous under such a condition, and then both substrates are contacted and pressed.
In this case however, the thin glass substrate cannot be kept by adsorbing to the pressurization unit by a vacuum adsorption method. Accordingly, it should be kept by an electrostatic adsorption method, the substrate keeping method by the electrostatic adsorption methods so far proposed is a method for keeping a glass substrate using an electrostatic adsorption pad having a plane form, and contact of these electrostatic adsorption elements to the glass substrate surface extends a broad range. Accordingly, there is a possibility of causing scratches and the like on the glass substrate surface. A device of a display is formed on the glass substrate surface in the subsequent step, but it is difficult to form it when scratches and the like are present.

The present invention has been made by taking the aforementioned problems into consideration. That is, an object thereof is to provide a device capable of conveniently and economically producing a laminated glass substrate which can inhibit generation of glass defects caused by foreign materials such as bubbles and dusts contaminated into glass substrates and can be treated by an existing production line without generating an etch pit so that almost all of the scratches, stains and the like that spoil formation of a display device are not present on the forming surface of the display device of a thin glass substrate. Also, another object thereof is to provide a method for producing a laminated glass substrate using the device.

### MEANS FOR SOLVING THE PROBLEMS

With the aim of solving the aforementioned problems, the present inventors have conducted intensive studies, thereby accomplishing the invention.
Namely, the present invention relates to the following items (1) to (11).
(1) A glass substrate lamination device for laminating two glass substrates, which comprises:
   an upper substrate supporting unit configured to absorb and support an upper glass substrate;
   a lower substrate supporting unit configured to mount and support a lower glass substrate;
   a seal unit configured to make a space between the upper substrate supporting unit and the lower substrate supporting unit into an air tight state; and
   a decompression unit configured to decompress said space surrounded by the upper substrate supporting unit, the lower substrate supporting unit and the seal unit;
   wherein the upper substrate supporting unit has, on a lower surface thereof, a substrate adsorption unit having any one of shapes of the following (A), (B) and (C):
      (A) a substrate adsorption unit having a rectangular frame shape,
      (B) a substrate adsorption unit having a shape comprising a rectangular frame and a straight line or curved line which connects each of facing one pair or two pairs of sides among four sides constituting the rectangle of said rectangular flame, and
      (C) a substrate adsorption unit having a shape comprising a plurality of mutually crossing straight lines or curved lines.
(2) The glass substrate lamination device according to (1), which further comprises a compressed air supplying unit configured to blow a compressed air downwardly to an upper surface of the upper glass substrate.
(3) The glass substrate lamination device according to claim 1 or 2, wherein the substrate adsorption unit has a width of 20 mm or less.
(4) The glass substrate lamination device according to any one of (1) to (3), wherein the substrate adsorption unit has an electrostatic adsorption element or a pressure-sensitive adhesive member.
(5) The glass substrate lamination device according to (4), wherein a base material for holding an electrode, of the electrostatic adsorption element, is a polyimide film.
(6) A method for producing a laminated glass substrate by laminating two glass substrates of a thin glass substrate and a supporting glass substrate using the glass substrate lamination device according to any one of (1) to (5), said method comprising:
   allowing the thin glass substrate adsorbed by the substrate adsorption unit possessed by the upper substrate supporting unit and the supporting glass substrate which has a resin layer on an upper surface thereof and is mounted on the lower substrate supporting unit to face each other;
   decompressing inside of the space surrounded by the upper substrate supporting unit, the lower glass substrate supporting unit and the seal unit by the decompression unit; and thereafter,
   allowing the thin glass substrate to contact with the supporting glass substrate, followed by pressurizing, thereby laminating said two glass substrates via the resin layer.
(7) The method for producing a laminated glass substrate according to (6), wherein after allowing the thin glass substrate to contact with the supporting glass substrate, a compressed air is blown downwardly to an upper surface of the thin glass substrate by the compressed air supplying unit.
(8) The method for producing a laminated glass substrate according to (6) or (7), wherein after allowing the thin glass substrate to contact with the supporting glass substrate, a pressurization treatment is carried out within a range of from 0.1 MPa to 1 MPa in the space surrounded by the upper substrate supporting unit, the lower substrate supporting unit and the seal unit or in a separate pressurization device.
(9) The method for producing a laminated glass substrate according to any one of (6) to (8), wherein, when an upper surface area of the thin glass substrate is regarded as So, and a contact area of the substrate adsorption unit with the thin glass substrate as S₁, a relational expression 0.02 ≤ S₁/S₀ ≤ 0.1 is satisfied.
(10) The method for producing a laminated glass substrate according to any one of (6) to (9), wherein the substrate adsorption unit has an electrostatic adsorption element and the electrostatic adsorption element has an adsorbing strength for the thin glass substrate of 40 mN/cm² or more at an application voltage of 1 kV.
(11) The method for producing a laminated glass substrate according to any one of (6) to (10), wherein the resin layer comprises at least one kind selected from the group consisting of an acrylic resin, a polyolefin resin, a polyurethane resin and a silicone resin.

### ADVANTAGE OF THE INVENTION

According to the invention, there can be provided a device capable of conveniently and economically producing a laminated glass substrate which can inhibit generation of glass defects caused by foreign materials such as bubbles and dusts contaminated into glass substrates and can be treated by an existing production line without generating an etch pit so that almost all of the scratches, stains and the like that spoil formation of a display device are not present on the forming surface of the display device of a thin glass substrate. Also, there is provided a method for producing a laminated glass substrate using the device.

### BRIEF DESCRIPTION OF THE DRAWINGS

Figs. 1(a) to (c) are sectional views of a suitable example of the lamination device of the invention.
Fig. 2 is a plan view of a part of the suitable example of the lamination device of the invention.
Figs. 3(a) to (c) are plan views of an electrostatic adsorption element of a suitable example of the lamination device of the invention.
Fig. 4 is a plan view of the electrostatic adsorption element of comparative example.

### MODE FOR CARRYING OUT THE INVENTION

The invention is described in detail.
The lamination device of the invention is described firstly, and the production method of the invention is described thereafter.

The lamination device of the invention is described.
The lamination device of the invention is a glass substrate lamination device in which two glass substrates are laminated, namely a glass substrate lamination device which is equipped with an upper substrate supporting unit configured to absorb and support the upper glass substrate, a lower substrate supporting unit configured to mount and support the lower glass substrate, a seal unit configured to make the space between the upper substrate supporting unit and the lower substrate supporting unit into an air tight state and a decompression unit configured to decompress the space surrounded by the upper substrate supporting unit, the lower substrate supporting unit and the seal unit, wherein the upper substrate supporting unit has, on the lower surface thereof, a substrate adsorption unit having a specific shape.

A suitable example of the lamination device of the invention is mentioned and described using drawings.

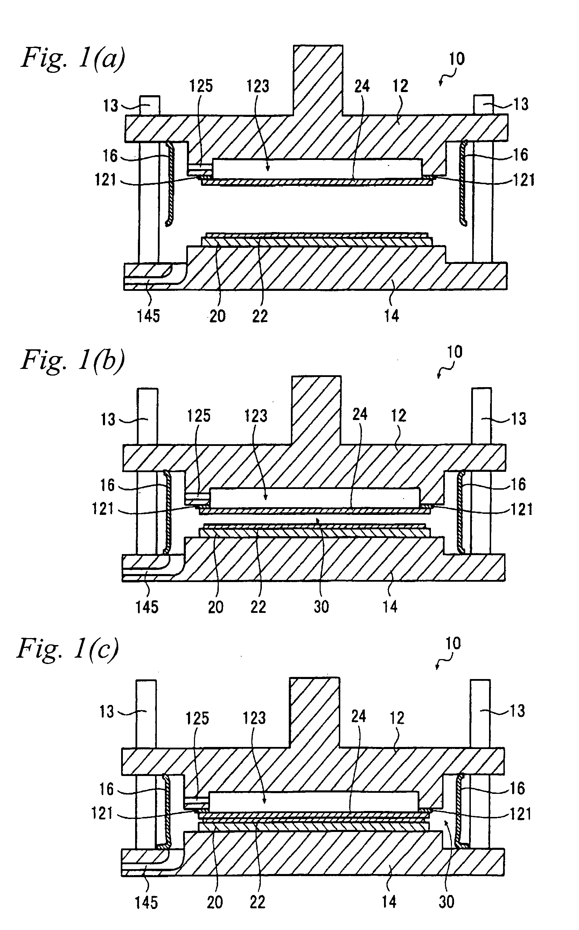

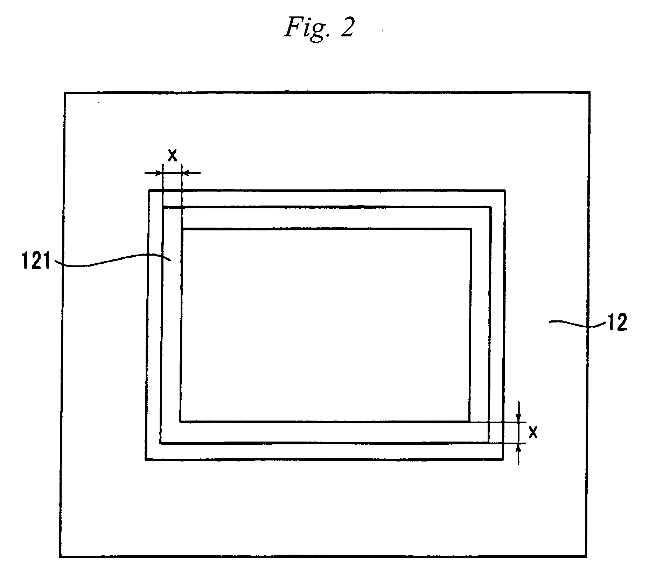

Fig. 1 and Fig. 2 are drawings showing a lamination device 10 as a suitable example of the lamination device of the invention. Fig. 1(a) to (c) are sectional views and Fig. 2 is a drawing where only an upper surface plate 12 alone as the upper substrate supporting unit (a state in which a thin glass substrate 24 is not adsorbed) is viewed from the lower side. In this connection, description of a portion where a column 13 and a seal 16 are connected is omitted in Fig. 2.

The lamination device 10 in Fig. 1 is equipped with the upper surface plate 12 as the upper substrate supporting unit, a lower surface plate 14 as the lower substrate supporting unit and the seal 16 as a seal unit, and further equipped with a decompression unit which is not shown in the drawing.
In addition, in Fig. 1, the upper surface plate 12 adsorbs the thin glass substrate 24 and the lower surface plate 14 fixes a supporting glass substrate 20. The supporting glass substrate 20 has a resin layer 22 on its upper surface, and its lower surface is contacted with the lower surface plate 14.
In this connection, the glass substrate which adsorbs the upper surface plate 12 is regarded as the "thin glass substrate 24" for the sake of description, so that the upper surface plate 12 can adsorb even when it is not a "glass substrate whose thickness is thin".

The lower surface plate 14 of the lamination device 10 is described.
The lower surface plate 14 is a stage which can keep the glass substrate under an almost horizontal state and the lower surface plate 14 itself is arranged almost horizontally. In addition, the lower surface plate 14 can fix a glass substrate on its upper surface. When the two glass substrates are adsorbed under compression by keeping the lower surface plate 14 and upper surface plate 12 close, a force is added to the glass substrate mounted on the stage, but in that case, the lower surface plate 14 can be kept by fixing a glass substrate at such a degree that the glass substrate does not shift.
Fig. 1(a) to (c) show a state in which the supporting glass substrate 20 having the resin layer 22 is fixed and kept on the upper surface of the lower surface plate 14.

In this case, it is desirable that the face of the lower surface plate 14, which contacts with the supporting glass substrate 20, namely the upper surface of lower surface plate 14 on which the supporting glass substrate 20 is mounted, is not a horizontal face but for example a pear shape face.
In addition, in the lamination device 10, a decompression hole 145 to be used in decompressing the space 30 surrounded by the upper surface plate 12, lower surface plate 14 and seal 16 is formed on the lower surface plate 14.

The upper surface plate 12 of the lamination device 10 is described.
The upper surface plate 12 is supported by the column 13 and arranged almost horizontally on the upper side of the lower surface plate 14 in such a manner that it faces the lower surface plate 14. In addition, the upper surface plate 12 can shift vertically via the column 13 while keeping the state of facing the lower surface plate 14. Fig. 1(b) shows a state in which the upper surface plate 12 is shifted downward from the state of Fig. 1(a) and the lower end of the seal 16 touched with the lower surface plate 14. Also, Fig. 1(c) shows a state in which the upper surface plate 12 is shifted further downward from the state of Fig. 1 (b) and the thin glass substrate 24 and the supporting glass substrate 20 are closely contacted via the resin layer 22.
According to the embodiment shown in Fig. 1, the thin glass substrate 24 and the support glass plate 20 were closely adhered via the resin layer 22 by the upward and downward shifting of the upper surface plate 12 alone, but the invention is not limited thereto, and these may be closely adhered by the upward and downward shifting of the lower surface plate 14 alone or these may be closely adhered by the upward and downward shifting of both of the upper surface plate 12 and lower surface plate 14.

The upper surface plate 12 has an electrostatic adsorption element 121 as a substrate adsorption unit on a part of its lower surface and can apply voltage to the electrostatic adsorption element 121 by a device not shown in the drawing. When applied, a glass substrate (thin glass substrate 24) can be adsorbed to the lower surface of the electrostatic adsorption element 121 by electrostatic force. In this case, the thin glass substrate 24 can be adsorbed while keeping almost parallel state with the supporting glass substrate 20 mounted on the upper surface of the lower surface plate 14.
In addition, since there is a case in which the thin glass substrate 24 adsorbed to the electrostatic adsorption element 121 bends, it is desirable to form a space 123 between the upper surface of the thin glass substrate 24 and the lower surface of the upper surface plate 12 as shown in Fig. 1. When the space 123 is present, it is necessary that an air hole 125 is formed on the upper surface plate 12 for connecting the space 123 with a space 30 which is described later. This is because the space 123 can also be made into a decompressed state similar to the case of the space 30.

The base material for electrode keeping in the electrostatic adsorption element 121 is not limited with the proviso that it can adsorb a glass substrate, and for example, a conventionally known material can be used. For example, an organic film or a ceramics can be used. In addition, since a compressive stress is added to the electrostatic adsorption element 121 when the thin glass substrate 24 and the supporting glass substrate 20 are closely adhered, an organic film is desirable, and it is desirable that it is a polyimide film.

In addition, shape of the electrostatic adsorption element 121 is not limited, and for example, it is a rectangular frame shape as shown in Fig. 2. Such a rectangular shape of electrostatic adsorption element 121 almost does not form scratches, stains and the like which inhibit formation of a display device, on the forming surface of the display device of a thin glass substrate 24 (namely, the main surface which does not adhere closely to the resin layer). This is because a display device is not generally formed on the outermost frame part of a glass substrate in forming the display device on the surface of the glass substrate. When it is such a rectangular shape, it can be adsorbed by the electrostatic adsorption element even when the thin glass substrate 24 is large (e.g., a glass plate of 1000 mm x 1000 mm, 0.4 mm in thickness).
In this connection, it is desirable that the upper substrate supporting unit and lower substrate supporting unit of the lamination device of the invention have such sizes that two glass substrates having such sizes can be laminated.

Also, it is preferable that width of the electrostatic adsorption element 121 (the length shown by "x" in Fig. 2) is 20 mm or less, more preferably from 1 mm to 15 mm, more preferably from 3 mm to 8 mm, further preferably about 5 mm. In the case of such a width, the electrostatic adsorption element 121 can adsorb the thin glass substrate 24 relatively easily. In addition, in the case of such a width, it is preferable because the number of displays which can be cut out from the thin glass substrate becomes large.

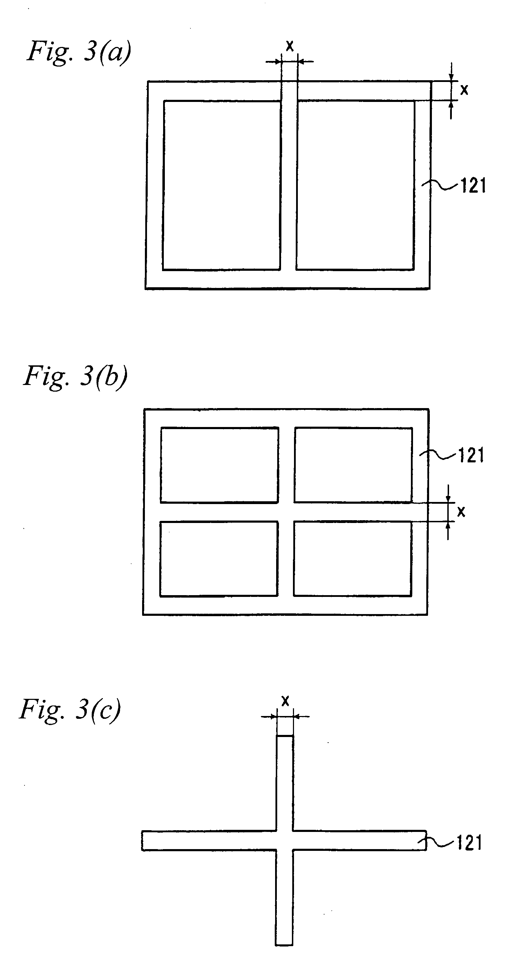

Also, in addition to the rectangular frame shape shown in Fig. 2, shape of the electrostatic adsorption element 121 may be the shapes shown in Fig. 3(a) to (c). Fig. 3(a) is a shape comprising a rectangular frame and a straight line which connects the center of a pair of facing sides among the four sides constituting the rectangle of the rectangular frame. Fig. 3(b) is a shape comprising a rectangular frame and straight lines which connect respective centers of two pairs of facing sides among the four sides constituting the rectangle of the rectangular frame. Fig. 3(c) is a shape comprising mutually perpendicular two straight lines.
In this case, according to the lamination device of the invention, shape of the electrostatic adsorption element 121 may be a case in which the "straight line which connects the center of a pair of sides" in Fig. 3(a) is not a "center", and also may be not a "straight line" but a "curved line". Also, it is the same in the case of Fig. 3(b) and (c). In addition, the "two straight lines" in Fig. 3(c) may be straight lines of 3 or more, and these may be not "perpendicular two lines" but "crossing two lines". When the shape of displays and the like to be formed by cutting off from the thin glass substrates is rectangular, a "straight line" is more preferable than a "curved line". This is because the number of displays and the like which can be cut out becomes large. When the shape of displays and the like is not rectangular, a "curved line" may be preferable in some cases.

According to the lamination device of the invention, the substrate adsorption unit may be a pressure-sensitive adhesive member other than the above-mentioned electrostatic adsorption element. Specifically, as the pressure-sensitive adhesive member, a silicone resin pressure-sensitive adhesive member, an acrylic resin pressure-sensitive adhesive member, a urethane resin pressure-sensitive adhesive member, a natural rubber pressure-sensitive adhesive member and the like can be mentioned.

The seal 16 of the lamination device 10 is described.
The seal 16 is present on both sides of the upper surface plate 12 and lower surface plate 14. In addition, it can form an air tight space 30 with the upper surface plate 12, lower surface plate 14 and seal 16. The space 30 is a space which includes a partial space between the upper surface plate 12 and lower surface plate 14.
According to the lamination device 10, upper end of the seal 16 is fixed to the upper surface plate 12, and by closing the upper surface plate 12 to the lower surface plate 14, lower end of the seal 16 contacts with the lower surface plate 14 so that the air tight space 30 can be formed. Though the space 30 is not formed in Fig. 1(a), the space 30 is formed as shown in Fig. 1(b) when lower end of the seal 16 contacts with the lower surface plate 14 by shifting the upper surface plate 12 downward from the state of Fig. 1(a). In addition, as shown in Fig. 1(b), the air tight space 30 can be formed while keeping the state in which the thin glass substrate 24 adsorbed to the electrostatic adsorption element 121 of the upper surface plate 12 is separated from the resin layer 22.
As shown in Fig. 1(b), after forming the space 30, inside of the space 30 can be decompressed by the decompression unit via the decompression hole 145. When inside of the space 30 made into a decompressed state, inside of the space 123 also becomes the same degree of decompressed state via the air hole 125.

As a suitable example of the lamination device of the invention, the above-mentioned lamination device 10 can be mentioned.

It is preferable that the lamination device of the invention is further equipped with a compressed air supplying unit configured to blow a compressed air downwardly to the upper surface of the upper glass substrate.
For example, when the upper surface plate 12 has a compressed air supplying unit in the lamination device 10 which has the substrate adsorption unit of the aforementioned shape shown in Fig. 2, it is preferable because, for example under the state of Fig. 1(c), the thin glass substrate 24 and the resin layer 22 can be contacted further closely by blowing the compressed air on the vicinity of the center of gravity of upper surface of the thin plate substrate 24 directing from the upper side to the lower side.
Since the upper substrate supporting unit has a plurality of compressed air supplying units (not shown in the drawing), it is preferable when a compressed air can be blown onto a plurality of places of the upper surface of the upper glass substrate.

Materials, sizes and the like of the respective members constituting the lamination device of the invention are not particularly limited and may be the same, for example, as those of the conventionally known vacuum press devices.

Next, the production method of the invention is described.
The production method of the invention is a method for producing a laminated glass substrate wherein two glass substrates of a thin glass substrate and a supporting glass substrate are laminated using the above-mentioned lamination device of the invention, which is a method for producing a laminated glass substrate in which the thin glass substrate adsorbed by the substrate adsorption unit possessed by the upper substrate supporting unit and the supporting glass substrate having a resin layer on upper surface thereof and is mounted on the lower substrate supporting unit, are allowed to face each other, the space surrounded by the upper substrate supporting unit, the lower side substrate supporting unit and the seal unit is decompressed by the decompression unit, and then the two glass substrates are laminated via the resin layer by allowing the thin glass substrate to contact with the supporting glass substrate, followed by pressurizing.

According to the production method of the invention, it is preferable to firstly adsorb the thin glass substrate to the substrate adsorbing unit possessed by the upper substrate supporting unit. The adsorbing method is not limited, but for example when the lamination device 10 as the suitable example is used, there may be mentioned a method in which the thin glass substrate 24 is firstly mounted on the upper surface of the lower surface plate 14, the electrostatic adsorption element 121 and thin glass substrate 24 are then closely adhered by lowering the upper surface plate 12, the thin glass substrate 24 is adsorbed by applying voltage to the electrostatic adsorption element, and then the upper surface plate 12 is lifted. In this case, when horizontal level and smoothness of the surface of the lower surface plate 14 on which the thin glass substrate 24 was mounted are high, the thin glass substrate 24 is closely adhered to the surface of the lower surface plate 14 so that it becomes difficult to rise the upper surface plate 12 while keeping the state of adsorbing the thin glass substrate by the electrostatic adsorption element 121, which is not preferable. Accordingly, it is preferable that upper surface of the lower surface plate 14 has a pear skin shape or a part of the upper surface has grooves.

Also, it is preferable that adsorbing strength of the electrostatic adsorption element 121 for the thin glass substrate 24 is 40 mN/cm² or more at an application voltage of 1 kV. This is because the adsorption becomes further strong.
In addition, adsorption capacity of the electrostatic adsorption element lowers in order of conductor>semiconductor>>insulator, and particularly, adsorption capacity of non-alkali glass is further low in comparison with that of soda lime glass, but when the adsorption capacity is 40 mN/cm² or more, preferably 60 mN/cm² or more, further preferably 80 mN/cm² or more, at an application voltage of 1 kV, as described in the above, it can be easily kept by the upper substrate supporting unit even when the thin glass substrate 24 is non-alkali glass, which is preferable.
In this connection, properties, production method and the like of the thin glass substrate itself are described later.

According to the production method of the invention, the supporting glass substrate is mounted on the lower substrate support unit, preferably after adsorbing the thin glass substrate to the substrate adsorption unit in the above-mentioned manner. In this case, the resin layer is formed in advance on the upper surface of the lower supporting glass substrate, and in carrying out the mounting, the supporting glass substrate is mounted on the lower substrate supporting unit in such a manner that the resin layer becomes the upper side. Thereafter, the thin glass substrate and the supporting glass substrate are faced each other as shown in Fig. 1 (a).
In this connection, properties, production methods and the like of the resin layer and supporting glass substrate itself are described later.

According to the production method of the invention, after facing the thin glass substrate and supporting glass substrate in the above-mentioned manner, an air tight space is formed by the upper substrate supporting unit, lower substrate supporting unit and seal unit. For example, as shown in Fig. 1(b), the air tight space 30 can be formed by lowering the upper surface plate 12, thereby closely adhering the lower end of the seal 16 onto the upper surface of the lower surface plate 14. The air tight space in this case means a space sealed to such a degree that air does not enter into the inside from the outside.

Next, inside of the space surrounded by the upper substrate supporting unit, lower substrate supporting unit and seal unit is decompressed by a decompression unit. For example, under the state shown in Fig. 1(b), inside of the space 30 is decompressed via the decompression hole 145, using a conventionally known decompression device. In this case, the space 123 is also decompressed via the air hole 125. By this, the thin glass substrate 24 can keep an almost horizontal state. When the air hole 125 is not present, there is a possibility of causing deformation of the thin glass substrate 24 due to generation of a pressure difference between the space 123 and the space 30.

Next, the thin glass substrate and supporting glass substrate are contacted with each other and pressurized. For example, it can be carried out by lowering the upper surface plate 12 as shown in Fig. 1(c).
In this case, when upper surface area of the thin glass substrate is regarded as So, and contact area of the substrate adsorption unit with the thin glass substrate as S₁, it is preferable to satisfy a relational expression 0.02 ≤S₁/S₀ ≤ 0.1, more preferable to satisfy 0.025 ≤ S₁/S₀ ≤ 0.08, further preferable to satisfy 0.03 ≤ S₁/S₀ ≤ 0.06. This is because when within such a range, the thin glass substrate can be adsorbed by the substrate adsorbing unit relatively easily and the number of displays and the like which can be cut out from the thin glass substrate becomes large.

In this case, it is preferable to blow compressed air downward on the upper surface of the thin glass substrate by the compressed air supplying unit, after contacting the thin glass substrate with the supporting glass substrate. That is, it is preferable to blow compressed air downward on the upper surface of the thin glass substrate by the compressed air supplying unit, while pressurizing the thin glass substrate and supporting glass substrate, or after the pressurization. This is because adsorption of the thin glass substrate by the substrate adsorption unit becomes further strong.
In addition, according to the invention, it is preferable to accelerate close adhesion of the thin glass substrate 24 with the resin layer 22, by making the air tight space 30 into a pressurized state. Also, not by making the air tight space 30 into a pressurized state, close adhesion of the thin glass substrate 24 with the resin layer 22 may be accelerated by once cutting out the laminated glass substrate prepared by closely adhering the thin glass substrate and the resin layer from the lamination device 10, putting the laminated glass substrate into a separate pressurization device, and pressurizing inside of the pressurization device. The applying pressure is preferably from 0.1 MPa to 1 MPa, more preferably from 0.1 MPa to 0.6 MPa. When the applying pressure is less than 0.1 MPa, the close adhesion accelerating effect cannot be obtained sufficiently, which is not preferable. Also, when the applying pressure exceeds 1 MPa, it is necessary to newly arrange a large pressurization device, which is not economical.

In addition, when the thin glass substrate is closely adhered to the surface of the resin layer, it is preferable to laminate them under an environment of high cleanness, by thoroughly washing the surface of the thin glass substrate. Even when a foreign substance is contaminated into a gap between the resin layer and thin glass substrate, it does not exert influence upon the flatness of the surface of the thin glass substrate because the resin layer deforms, but the flatness becomes good as the cleanness becomes high, which is preferable.

By such a production method of the invention, a laminated glass in which two glass substrates are laminated via a resin layer can be obtained. Such a laminated glass is also called "laminated glass substrate of the invention" hereinafter.

The laminated glass substrate of the invention is described.
In the laminated glass substrate of the invention, the thin glass substrate is closely adhered with the resin layer by a considerably adjacent force caused by van der Waals force between relative solid molecules, namely closely adhering force. In this case, the supporting glass substrate and thin glass substrate can be kept under a laminated state.
In addition, since the laminated glass substrate of the invention is produced by the production method of the invention, the laminated glass substrate and the resin layer are laminated without taking bubbles.
Also, regarding the laminated glass substrate of the invention, there are almost no scratches, stains and the like which inhibit formation of a display device, on the forming surface of the display device of a thin glass substrate.

The thin glass substrate of the laminated glass substrate of the invention is described.
Thickness, shape, size, physical properties (heat contraction rate, surface shape, drug resistance and the like), composition and the like of the thin glass substrate are not particularly limited, and for example, may be the same as those of the glass substrate for conventional display device such as LCD, OLED and the like. It is preferable that the thin glass substrate is a glass substrate for TFT array.

Thickness of the thin glass substrate is preferably less than 0.7 mm, more preferably 0.5 mm or less, further preferably 0.4 mm or less. Also, it is preferably 0.05 mm or more, more preferably 0.07 mm or more, further preferably 0.1 mm or more.
Shape of the thin glass substrate is not limited but is preferably rectangle.
Size of the thin glass substrate is not limited, but in the case of the rectangle, it may be from 100 mm to 2000 mm x from 100 mm to 2000 mm, and is more preferably from 500 mm to 1000 mm x from 500 mm to 1000 mm.

In this connection, regarding the thickness and size of the thin glass substrate, the thickness is represented by the average value of values obtained by measuring 9 points within the plane using a laser focus displacement meter, and the size means values obtained by respectively measuring shorter side and longer side using a steel rule.

Even by such thickness and size, the laminated glass substrate of the invention can easily perform separation of its thin glass substrate and supporting glass substrate.

Heat contraction rate, surface shape, drug resistance and the like of the thin glass substrate are not particularly limited, too, and differ depending on the kind of the display device to be produced.
In addition, it is preferable that heat contraction rate of the thin glass substrate is small. Specifically, it is preferable to use those which have a linear expansion coefficient, as an index of heat contraction rate, of 200 x 10⁻⁷/°C or less. The linear expansion coefficient is more preferably 100 x 10⁻⁷/°C or less, further preferably 45 x 10⁻⁷/°C or less. The reason for this is that a high precision display device cannot be prepared when the heat contraction rate is large.
In this connection, the linear expansion coefficient according to the invention means the case defined by JIS R3102 (1995).

Composition of the thin glass substrate may be the same as that of, for example, alkali glass or non-alkali glass. Particularly, non-alkali glass is preferable because it has a small heat contraction rate.

The supporting glass substrate of the laminated glass substrate of the invention is described.
The supporting glass substrate supports the thin glass substrate via the resin layer and reinforces strength of the thin glass substrate.

Thickness, shape, size, physical properties (heat contraction rate, surface shape, drug resistance and the like), composition and the like of the supporting glass substrate are not particularly limited.
Thickness of the supporting glass substrate is not particularly limited, but it is preferable that it has such a thickness that it can be treated on the current production line. For example, it has a thickness of preferably from 0.1 mm to 1.1 mm, more preferably from 0.3 mm to 0.8 mm, further preferably from 0.4 mm to 0.7 mm.
For example, when the current production line is designed for treating a substrate having a thickness of 0.5 mm and thickness of the thin glass substrate is 0.1 mm, the total of the thickness of supporting glass substrate and the thickness of resin layer is set to 0.4 mm. In addition, although it is most general that the current production line is designed for treating a glass substrate having a thickness of 0.7 mm, for example when thickness of the thin glass substrate is 0.4 mm, the total of the thickness of supporting glass substrate and the thickness of resin layer is set to 0.3 mm.
It is preferable that the thickness of supporting glass substrate is thicker than that of the thin glass substrate.

Shape of the supporting glass substrate is not limited, but is preferably rectangular.
Size of the supporting glass substrate is not limited but is preferably similar to that of the thin glass substrate and is preferably slightly larger than that of the glass substrate (the lengthwise or crosswise direction is larger than from 0.05 mm to 10 mm). The reason for this is that the edge of the thin glass substrate can be easily protected from its contact with an alignment device such as a locating pin at the time of producing a panel for display device, and separation of the thin glass substrate and supporting glass substrate can be carried out further easily.
The linear expansion coefficient of the supporting glass substrate may be substantially the same as that of the thin glass substrate or different. When substantially the same, it is preferable from the viewpoint that a warpage is hardly generated in the thin glass substrate or supporting glass substrate in carrying out a heat treatment of the laminated glass substrate of the invention.

The difference in linear expansion coefficient between the thin glass substrate and supporting glass substrate is preferably 300 x 10⁻⁷/°C or less, more preferably 100 x 10⁻⁷/°C or less, further preferably 50 x 10⁻⁷/°C or less.

Composition of the supporting glass substrate may be the same as that of, for example, alkali glass or non-alkali glass. Particularly, non-alkali glass is preferable because it has a small heat contraction rate.

The resin layer of the laminated glass substrate of the invention is described.
According to the laminated glass substrate of the invention, the resin layer is fixed to one main surface (to be referred to as "first main surface" of supporting glass substrate hereinafter, also, the other main surface is referred sometimes to as "second main surface") of the supporting glass substrate. Also, the resin layer is closely adhered to one main surface (to be referred to as "first main surface" of thin glass substrate hereinafter, also, the other main surface is referred sometimes to as "second main surface") of the thin glass substrate, but can be easily separated. That is, the resin layer has an easily separable property for the thin glass substrate.

According to the laminated glass substrate of the invention, it is considered that the resin layer and thin glass substrate are not adhered by a pressure-sensitive adhesive force possessed by a pressure-sensitive adhesive, but considered to be adhered by a force caused by van der Waals force between solid molecules, namely a closely adhering force.

Thickness of the resin layer is not particularly limited. From 1 µm to 100 µm is preferable, from 5 µm to 30 µm is more preferable, and from 7 µm to 20µm is further preferable. This is because close adhesion of the thin glass substrate with the resin layer becomes sufficient when thickness of the resin layer is within such a range.
This is also because generation of deformation defect of the thin glass substrate can be inhibited even when bubbles or foreign substances are present. In addition, when thickness of the resin layer is too thick, it is not economical because a period of time and a material are required for forming it.

In this case, the thickness of resin layer means average value of values obtained by measuring 9 points within the plane using a laser focus displacement meter.
In this connection, the resin layer may include two layers or more. In that case, the "thickness of resin layer" means total thickness of all layers.
In addition, when the resin layer includes two layers or more, kinds of resins which form respective layers may be different.

The resin layer has a surface tension of the resin layer surface for the first main surface of the thin glass substrate of preferably 30 mN/m or less, more preferably 25 mN/m or less, further preferably 22 mN/m or less. This is because such a surface tension renders possible its easy separation from the thin glass substrate, and at the same time, its close adhesion with the thin glass substrate also becomes sufficient.

In addition, it is preferable that the resin layer comprises a material having a glass transition point of lower than room temperature (approximately 25°C) or a material which does not have glass transition point. This is because it becomes a non pressure-sensitive adhesiveness resin layer and has a further easily separable property so that it can be easily separated from the thin glass substrate, and at the same time, its close adhesion with the thin glass substrate also becomes sufficient.

In addition, it is preferable that the resin layer has heat resistance. This is because, for example when a member for display device is formed on the second main surface of the thin glass substrate, a laminated glass substrate having a resin layer is subj ected to a heat treatment.
In addition, too high modulus of elasticity of the resin layer is not preferable because its close adhesion with the thin glass substrate becomes low. Also, too low modulus of elasticity is not preferable because the easy separation property becomes low.

Kind of the resin which forms the resin layer is not particularly limited. For example, there may be mentioned an acrylic resin, a polyolefin resin, a polyurethane resin and a silicone resin. Two resins can also be used by mixing them. Particularly, a silicone resin is preferable. This is because a silicone resin is excellent in heat resistance and also excellent in easy separation property for thin glass substrate. A silicone resin layer is also preferable from the viewpoint that the easy separation property does not deteriorate for the most part even when treated, for example, at about 400°C for about 1 hour. In addition, this is because since silicone resin undergoes condensation reaction with silanol groups on the supporting glass substrate surface, the silicone resin layer can be easily fixed to the surface (first main surface) of the supporting glass substrate.

In addition, it is preferable that the resin layer includes, among silicone resins, a silicone for release paper, preferably a cured product thereof. The silicone for release paper uses, as the main component, a silicone containing a straight chain dimethylpolysiloxane in the molecule thereof. A resin layer formed by curing a composition containing this main component and a crosslinking agent on the surface (first main surface) of the supporting glass substrate using a catalyst, a photopolymerization initiator and the like is preferable because it has excellent easy separation property. In addition, even when bubbles, dusts and the like foreign substances are contaminated into the gap between the thin glass substrate and resin layer, generation of deformation defect of the thin glass substrate can be inhibited because it has high flexibility, which is preferable.

Depending on its curing mechanism, such a silicone for release paper is classified into a condensation reaction type silicone, an addition reaction type silicone, an ultraviolet ray curing type silicone and electron beam curing type silicone, and each of them can be used. Among them, the addition reaction type silicone is preferable. This is because it is easy to carry out curing reaction, its degree of easy separation property in forming the resin layer is proper and its heat resistance is also high.

In addition, configurationally, there are a solvent type, an emulsion type and non-solvent type in the silicone for release paper, and each type can be used. Among them, the non-solvent type is preferable. This is because it is excellent in view of its productivity, safety and environmental characteristics. Also, this is because it does not contain a solvent which generates bubbles so that bubbles hardly remain in the resin layer at the time of curing in forming the resin layer, namely at the time of heat curing, ultraviolet ray curing or electric beam curing.

In addition, as the commercially available trade name or model number of the silicone for release paper, there may be specifically mentioned KNS-320A, KS-847 (both mfd. by Shin-Etsu Silicone), TPR 6700 (mfd. by GE Toshiba Silicone), a combination of vinylsilicone "8500" (mfd. by Arakawa Chemical Industries, Ltd.) with methylhydrogenpolysiloxane "12031" (mfd. by Arakawa Chemical Industries, Ltd.), a combination of vinylsilicone "11364" (mfd. by Arakawa Chemical Industries, Ltd.) with methylhydrogenpolysiloxane "12031" (mfd. by Arakawa Chemical Industries, Ltd.), a combination of vinylsilicone "11365" (mfd. by Arakawa Chemical Industries, Ltd.) with methylhydrogenpolysiloxane "12031" (mfd. by Arakawa Chemical Industries, Ltd.), and the like. In this connection, each of the KNS-320A, KS-847 and TPR 6700 is a silicone which contains a crosslinking agent in advance as the main component.
In addition, it is preferable that the silicone resin which forms the resin layer has such a property that components in the silicone resin layer can be hardly transferred into the thin glass substrate, namely a low silicone transferring property.

The method for forming a resin layer on the surface (first main surface) of the supporting glass substrate is not particularly limited. For example, a method in which a film-shaped resin is applied to the surface of a supporting glass substrate can be mentioned. Specifically, there may be mentioned a method in which a film is applied to the first main surface of a supporting glass substrate, after carrying out a surface modifying treatment (priming treatment) on the surface of the supporting glass substrate in order to provide a high adhesive force with the film surface. For example, there may be exemplified a chemical method (primer treatment) such as a silane coupling agent which chemically improves closely adhering force , a physical method such as a flame treatment which increases surface active groups, a mechanical treatment method such as a sand blast treatment which increases hooking by increasing roughness of the surface, and the like.

In addition, there may be mentioned a method in which a resin composition which becomes a resin layer is coated on the first main surface of a supporting glass substrate for example by a conventionally known method. As the conventionally known method, there may be mentioned a spray coating, a die coating, a spin coating, a dip coating, a roll coating, a bar coating, a screen printing and a gravure coating. It can be optionally selected from these methods in response to the kind of the resin composition.
For example, when a non-solvent type silicone for release paper is used as the resin composition, the die coating, spin coating or screen printing is preferable.

In addition, when a resin composition is coated on the first main surface of a supporting glass substrate, its coating amount is preferably from 1 g/m² to 100 g/m², more preferably from 5 g/m² to 20 g/m².
For example, when a resin layer comprising an addition reaction type silicone is formed, a resin composition containing a straight chain dimethylpolysiloxane in the molecule (main component), a crosslinking agent and a catalyst is coated on a supporting glass substrate by a conventionally know method such as the above-mentioned screen printing and the like, and then subjected to heat curing. The heat curing condition varies depending on the blending amount of the catalyst, but for example, when 2 pats by mass of a platinum-based catalyst is blended based on 100 parts by mass in total of the main component and crosslinking agent, the reaction is carried out in the atmospheric air at from 50°C to 250°C, preferably from 100°C to 200°C. In addition, the reaction time in this case is set to from 5 minutes to 60 minutes, preferably from 10 minutes to 30 minutes. In order to prepare a silicone resin layer having a low silicone transferring property, it is preferable to advance the curing reaction as thorough as possible so that unreacted silicone components do not remain in the silicone resin layer. The above-mentioned reaction temperature and reaction time are preferable because it renders possible no remaining of the unreacted silicone components in the silicone resin layer. When the reaction time is too longer than the above-mentioned case or the reaction temperature is too higher than that, there is a possibility that oxidation and degradation of the silicone resin simultaneously occur so that low molecular weight silicone components are formed and the silicone transferring property becomes high. Thorough advance of the curing reaction to prevent remaining of unreacted silicone components in the silicone resin layer is also preferable for improving separation property after the heat treatment.

In addition, for example when a resin layer is produced using a silicone for release paper, a silicone resin layer is formed by heat-curing the silicone for release paper coated on a supporting glass substrate, and then a thin glass substrate is laminated on the silicone resin forming surface of the supporting glass substrate by the production method of the invention which uses the lamination device of the invention. By heat-curing the silicone for release paper, the silicone resin cured product chemically binds to the supporting glass substrate surface. Also, the silicone resin layer binds to the supporting glass substrate surface by an anchor effect. By these actions, the silicone resin layer is firmly fixed to the supporting glass substrate.

By using such a laminated glass substrate of the invention, a support attached-panel for a display device can be produced.
This support attached-panel for a display device further has a member for a display device on the second main surface of the thin glass substrate in the laminated glass substrate of the invention.
This support attached-panel for display device can be obtained by forming the member for a display device on the second main surface of the thin glass substrate in the laminated glass substrate of the invention. Since the laminated glass substrate of the invention obtained by the production method of the invention has almost no scratches, stains and the like, which inhibit formation of the display device, on the forming surface of the display device of a thin glass substrate, the member for a display device can be formed without a problem.

The member for a display device means various circuit patterns and the like such as a luminescent layer, a protective layer, an array, a color filter, a liquid crystal, a transparent electrode consisting of ITO, a hole injection layer, a hole transfer layer, a luminescent layer, an electron transfer layer and the like, which are possessed by the surface of glass substrates for conventional display devices such as LCD, OLED and the like.
It is preferable that the support attached-panel for a display device is prepared by forming a TFT array (to be referred simply to as "array" hereinafter) on the second main surface of the thin glass substrate of the laminated glass substrate of the invention.
Also included in the support attached-panel for display device are, for example, those in which other glass substrate (e.g., a glass substrate having a thickness of approximately 0.3 mm or more) on which a color filter is formed is further adhered to a support attached panel for display device in which an array is formed on the second main surface of the thin glass substrate.

In addition, a panel for display device can be obtained from such a support attached-panel for display device. A panel for display device can having a member for display device and a thin glass substrate can be obtained from a support attached-panel for display device, by separating the thin glass substrate and the resin layer fixed to the supporting glass substrate.

Also, a display device can be obtained from such a panel for display device. As the display device, LCD and OLED can be mentioned. As the LCD, a TN type, an STN type, an FE type, a TFT type and an MIM type can be mentioned.
The method for producing such display devices is not particularly limited, and it may be the same as a conventionally known method.
For example, when a TFT-LCD is produced as a display device, it may be similar to the conventionally known various steps such as a step for forming an array on a glass substrate, a step for forming a color filter, a step for pasting the array-formed glass substrate with the color filter-formed glass substrate (an array-color filter pasting step) and the like. More specifically, as the treatment carried out in these steps, for example, pure water washing, drying, film formation, resist application, exposure, development, etching and resist removal can be mentioned. Further, as steps which are carried out after carrying out the array-color filter adhering step, there are a liquid crystal injection step and an injection inlet sealing step which is carried out after carrying out such a treatment, and the treatments carried out in these steps can be mentioned.

In addition, in the case of producing OLED, various steps such as a step for forming a transparent electrode, a step for depositing a hole injection layer, a hole transfer layer, a luminescent layer, an electron transfer layer and the like, a step for sealing and the like are included as the process for forming an organic EL structure on the second main surface of a thin glass substrate, and as the treatments carried out in these steps, specifically for example, a film forming treatment, a deposition treatment, a sealing plate adhesion treatment and the like can be mentioned.

### EXAMPLES

### (Example 1)

Firstly, a supporting glass substrate of 720 mm in length, 600 mm in breadth, 0.4 mm in thickness and 38 x 10⁻⁷/°C in linear expansion coefficient (mfd. by Asahi Glass Co., Ltd., trade name "AN100") was washed with pure water and washed with UV to clean the surface.

Next, as the resins for forming a resin layer, a straight chain polyorganosiloxane having vinyl groups on both termini (mfd. by Arakawa Chemical Industries, Ltd., trade name "8500") and methylhydrogenpolysiloxane having hydrosilyl group in the molecule (mfd. by Arakawa Chemical Industries, Ltd., trade name "12031") were used. Subsequently, these were mixed with a platinum-based catalyst (mfd. by Arakawa Chemical Industries, Ltd., trade name "CAT12070") to prepare a mixture, coated on the supporting glass substrate with a size of 715 mm in length and 595 mm in breadth (coating amount 20 g/m²) using a screen printer and heat-cured in the atmospheric air at 180°C for 30 minutes to form a silicone resin layer of 20 µm in thickness. In this case, mixing ratio of the straight chain polyorganosiloxane and methylhydrogenpolysiloxane was adjusted such that molar ratio of hydrosilyl group and vinyl group became 1/1. The platinum-based catalyst was added in an amount of 5 parts by mass based on 100 parts by mass in total of straight chain polyorganosiloxane and methylhydrogenpolysiloxane.

Next, the first main surface (the surface which is contacted later with the silicone resin later) of a thin glass substrate of 720 mm in length, 600 mm in breadth, 0.3 mm in thickness and 38 x 10⁻⁷/°C in linear expansion coefficient (mfd. by Asahi Glass Co., Ltd., trade name "AN100") was washed with pure water and washed with UV to clean the surface.

Thereafter, a laminated glass substrate was produced using a vacuum heater press device. In this connection, the vacuum heater press device is the one shown in Fig. 1 and Fig. 2, prepared by changing a part corresponding to the "substrate adsorption unit" of a heater press device (MKP-200TV-WH-ST) manufactured by MIKADO TECHNOS CO., LTD. to a specified shape.

Illustrative laminated glass substrate production method using a vacuum heater press device is described using Fig. 1 and Fig. 2.
Shape of the electrostatic adsorption element (121) in the vacuum heater press device (lamination device 10) used in Example 1 is the rectangular frame shape shown in Fig. 2, and its width (X) is 5 mm. Also, external appearance of the frame almost coincides with the eternal appearance of the thin glass substrate. In addition, this electrostatic adsorption element (mfd. by Tomoegawa Co., Ltd.) is of a polyimide film base, and its adsorption to the thin glass substrate is 50 mN/cm²/1 kV. In this connection, ratio of the upper surface area So of the thin glass substrate and contacting area S₁ of the substrate adsorption unit with the thin glass substrate of this case, S₁/S₀ value, is 0.03.

A laminated glass substrate was produced in the following manner inside a room (under ordinary temperature, under ordinary pressure) using such a vacuum heater press device. Firstly, the thin glass substrate (24) was arranged on a predetermined position of the lower surface plate (14) in such a manner that the second main surface became upward.
Next, the upper surface plate fixed with the above-mentioned electrostatic adsorption element (121) was lowered, the lowering was stopped when the electrostatic adsorption element (121) contacted with the second main surface of the thin glass substrate (24), and 2 kV of voltage was applied to the electrostatic adsorption element (121). Thereafter, the electrostatic adsorption element (121) and the thin glass substrate (24) were adsorbed.

Next, the upper surface plate (12) was lifted 20 mm while applying the voltage. Thereafter, the supporting glass substrate (20) having the resin layer (22) was arranged on a predetermined position in such a manner that the resin layer (22) became upside.

Next, the upper surface plate (12) was again lowered and stopped when a gap between the resin layer (22) and the first main surface of the thin late glass substrate (24) became 3 mm. Under this condition, lower end of the seal (16) contacted with the upper surface of the lower surface plate (14) so that a gap between the upper and lower surface plates became an airtight space (30).
Thereafter, inside of the space (30) was made vacuous to -100 kPa.

Next, the upper surface plate (12) was lowered until the thin glass substrate (24) contacted with the electrostatic adsorption element (121). Under this condition, the electrostatic adsorption element (121) alone was contacted with the second main surface of the thin glass substrate (24). In addition, a pressure of 300 kN/m² was applied from the electrostatic adsorption element (121) to the second main surface of the thin glass substrate (24). After keeping this condition for 10 seconds, the vacuity was destroyed by cutting the applying voltage, the upper surface plate (12) was lifted, and the thus obtained laminated glass substrate (to be referred to as "laminated glass substrate 1") was pulled out.

In the laminated glass substrate 1, the thin glass substrate (24) and the supporting glass substrate (20) were closely adhered via the silicone resin layer (22) without generating bubbles, and there was no convexity defect and the smoothness was also proper.

In addition, in the laminated glass substrate 1, when the thin glass substrate (24) was separated from the supporting glass substrate (20) and the second main surface of the thin glass substrate (24) was observed by irradiating a high intensity lamp in a dark room, it was confirmed that inside of the plane other than the peripheral 5 mm was in a good surface condition of being completely free from scratches, stains and the like.

### (Comparative Example 1)

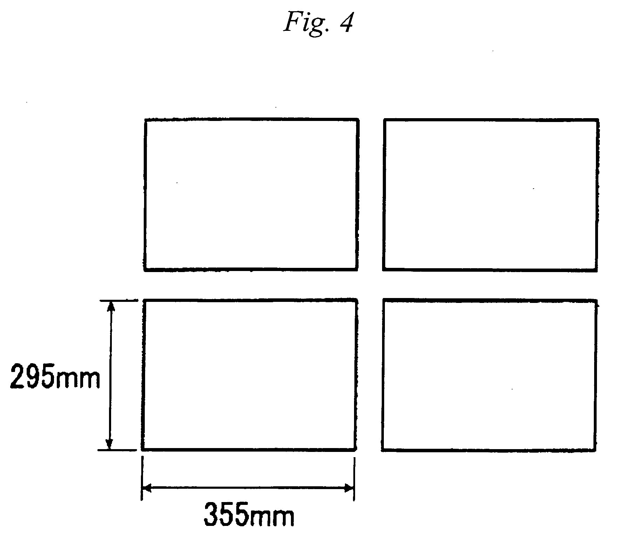

A laminated glass substrate ("laminated glass substrate 01") was obtained by carrying out the same operation of Example 1 except that a substance having the shape shown in Fig. 4 was used instead of the electrostatic adsorption element (121) used in Example 1 having the shape of Fig. 2. In this connection, ratio of the upper surface area So of the thin glass substrate and contacting area S₁ of the substrate adsorption unit with the thin glass substrate of this case, S₁/S₀ value, was 0.97.
As shown in Fig. 4, the electrostatic adsorption element used in Comparative Example 1 was a product of attaching four electrostatic adsorption elements, each having a rectangular shape of 295 mm in length and 355 mm in breadth. All of the respective gaps were set to 5 mm. This electrostatic adsorption element (mfd. by Tomoegawa Co., Ltd.) is of a polyimide film base, and its adsorption to the non-alkali glass was 10 mN/cm²/1 kV.

In the laminated glass substrate 01, the thin glass substrate and the supporting glass substrate were closely adhered via the silicone resin layer without generating bubbles, and there was no convexity defect and the smoothness was also proper.

However, in the laminated glass substrate 01, when the thin glass substrate was separated from the supporting glass substrate and the second main surface of the thin glass substrate was observed by irradiating a high intensity lamp in a dark room; a thin scratch-like flaw was found within the plane.

### (Comparative Example 2)

An attempt was made to prepare a laminated glass substrate 02 by carrying out the same operation of Example 1 except that width of the electrostatic adsorption element (121) used in Example 1 having the shape of Fig. 2 was thinned from 5 mm to 3 mm. In this case, ratio of the upper surface area So of the thin glass substrate and contacting area S₁ of the substrate adsorption unit with the thin glass substrate, S₁/S₀ value, was 0.018.
Firstly, the upper surface plate (12) was lowered, the lowering was stopped when the electrostatic adsorption element (121) contacted with the second main surface of the thin glass substrate (24), and 2 kV of voltage was applied to the electrostatic adsorption element (121). Thereafter, the electrostatic adsorption element (121) and the thin glass substrate (24) were adsorbed. Next, when the upper surface plate (12) was lifted 20 mm while applying the voltage, the thin glass substrate (24) was dropped due to insufficient adsorption force so that it was not able to advance the lamination process thereafter.

### (Comparative Example 3)

A laminated glass substrate 03 was obtained by carrying out the same operation of Example 1 except that width of the electrostatic adsorption element (121) used in Example 1 having the shape of Fig. 2 was thickened from 5 mm to 20 mm. In this case, ratio of the upper surface area So of the thin glass substrate and contacting area S₁ of the substrate adsorption unit with the thin glass substrate, S₁/S₀ value, was 0.12.

### (Example 2)

In Example 2, an LCD is produced using the laminated glass substrate 1 obtained in Example 1.
Two plates of the laminated glass substrate 1 are prepared, and then, respective devices are formed in the area 10 mm inside from the ends of each laminated glass substrate. One plate is subjected to an array forming step to form an array on the second main surface of the thin glass substrate. The remaining plate is subjected to a color filter forming step to form a color filter on the second main surface of the thin glass substrate. The laminated glass substrate on which an array is formed and the laminated glass substrate on which a color filter is formed are adhered via a sealing material, and then a mixed fluid of compressed air and water is blown on the ends of the single side of each laminate and respective supporting glass substrates were separated. A scratch which can lead to the lowering of strength is not found on the surface of the thin glass substrate after their separation.

Subsequently, thickness of each thin glass substrate is adjusted to 0.15 mm by a chemical etching treatment. Generation of an etch pit which can optically become a problem is not found on the surface of the thin glass substrate after their chemical etching treatment.

Thereafter, the thin glass substrate is cut and divided into 168 cells, each having a size of 51 mm in length and 38 mm in breadth, and then a liquid crystal cell is formed by carrying out a liquid crystal injection step and an injection inlet sealing step. An LCD is obtained by carrying out a step for pasting a polarizing plate to the thus formed liquid crystal cell and subsequently carrying out a module forming step. The LCD obtained in this manner does not generate a characteristic problem.

### (Comparative Example 4)

In Comparative Example 4, an LCD is produced using the laminated glass substrate 03 obtained in Comparative Example 3.
Two plates of the laminated glass substrate 03 are prepared, and then, respective devices are formed in the area 25 mm inside from the ends of each laminated glass substrate. A liquid crystal cell is produced thereafter by the method identical to the method of Example 2, but since only 132 of cells, each having a size of 51 mm in length x 38 mm in breadth, are able to be produced, efficiency of the LCD which can be prepared from the same size of substrate is reduced to 20 points or more in comparison with the 168 cells prepared in Example 2.

### (Example 3)

In Example 3, an LCD is produced using the laminated glass substrate 1 obtained in Example 1 and a non-alkali glass substrate having a thickness of 0.7 mm (mfd. by Asahi Glass Co., Ltd., trade name "AN100").
The laminated glass substrate 1 is prepared, and then, the area 10 mm inside from the ends of the laminated glass substrate 1 is subjected to a color filter forming step to form a color filter on the second main surface of the thin glass substrate of the laminated glass substrate 1. On the other hand, the non-alkali glass substrate is subjected to an array forming step to form an array on the other main surface.

The laminated glass substrate on which the color filter was formed was adhered via a sealing material with the non-alkali glass substrate on which the array is formed, and then a mixed fluid of compressed air and water is blown on the ends of the laminate glass substrate 1 side and the supporting glass substrate is separated. A scratch which can lead to the lowering of strength is not found on the surface of the thin glass substrate after its separation.

Subsequently, the result after separating the supporting glass substrate is divided into 168 cells, each having a size of 51 mm in length x 38 mm in breadth, using a laser cutter or a scribe and break method. Thereafter, a liquid crystal cell is formed by carrying out a liquid crystal injection step and an injection inlet sealing step. An LCD is obtained by carrying out a step for adhering a polarizing plate to the thus formed liquid crystal cell and subsequently carrying out a module forming step. The LCD obtained in this manner does not generate a characteristic problem.

### (Example 4)

In Example 4, an OLED is produced using the laminated glass substrate 1 obtained in Example 1.
An organic EL structure is formed on the thin glass substrate of the laminated glass substrate 1 by subjecting the area 10 mm inside from the ends of the laminated glass substrate 1 to a step for forming a transparent electron, a step for forming an auxiliary electrode, a step for depositing a hole injection layer, a hole transfer layer, a luminescent layer, an electron transfer layer and the like and a step for sealing them. Next, a mixed fluid of compressed air and water is blown on the ends of the laminate and the supporting glass substrate is separated. A scratch which can lead to the lowering of strength is not found on the surface of the thin glass substrate after its separation.

Subsequently, the thin glass substrate is divided into 288 cells, each having a size of 41 mm in length x 30 mm in breadth, using a laser cutter or a scribe and break method, and then an OLED is prepared by assembling the glass substrate on which an organic EL structure is formed and a facing substrate and carrying out a module forming step. The OLED obtained in this manner does not generate a characteristic problem.

While the invention has been described in detail and with reference to specific embodiments thereof, it will be apparent to one skilled in the art that various changes and modifications can be made therein without departing from the spirit and scope of the invention.
This application is based on Japanese Patent Application No. 2008-273081 filed on October 23, 2008, the entire contents of which are incorporated herein by reference.

### INDUSTRIAL APPLICABILITY

According to the invention, it can provide a device capable of conveniently and economically producing a laminated glass substrate which can inhibit generation of glass defects caused by foreign materials such as bubbles and dusts contaminated into glass substrates and can be treated by an existing production line without generating an etch pit so that almost all of the scratches, stains and the like that spoil formation of a display device are not present on the forming surface of the display device of a thin glass substrate. Also, it can provide a method for producing a laminated glass substrate using the device.

### DESCRIPTION OF THE REFERENCE NUMERALS AND SIGNS

- 10: Lamination device
- 12: Upper surface plate
- 121: Electrostatic adsorption element
- 123: Space
- 125: Air hole
- 13: Column
- 14: Lower surface plate
- 145: Decompression hole
- 16: Seal
- 20: Supporting glass substrate
- 22: Resin layer
- 24: Thin glass substrate
- 30: Space
- X: width of electrostatic adsorption element

## Claims

1. A glass substrate lamination device for laminating two glass substrates, which comprises:
an upper substrate supporting unit configured to absorb and support an upper glass substrate;
a lower substrate supporting unit configured to mount and support a lower glass substrate;
a seal unit configured to make a space between the upper substrate supporting unit and the lower substrate supporting unit into an air tight state; and
a decompression unit configured to decompress said space surrounded by the upper substrate supporting unit, the lower substrate supporting unit and the seal unit;
wherein the upper substrate supporting unit has, on a lower surface thereof, a substrate adsorption unit having any one of shapes of the following (A), (B) and (C):
(A) a substrate adsorption unit having a rectangular frame shape,
(B) a substrate adsorption unit having a shape comprising a rectangular frame and a straight line or curved line which connects each of facing one pair or two pairs of sides among four sides constituting the rectangle of said rectangular flame, and
(C) a substrate adsorption unit having a shape comprising a plurality of mutually crossing straight lines or curved lines.

2. The glass substrate lamination device according to claim 1, which further comprises a compressed air supplying unit configured to blow a compressed air downwardly to an upper surface of the upper glass substrate.

3. The glass substrate lamination device according to claim 1 or 2, wherein the substrate adsorption unit has a width of 20 mm or less.

4. The glass substrate lamination device according to any one of claims 1 to 3, wherein the substrate adsorption unit has an electrostatic adsorption element or a pressure-sensitive adhesive member.

5. The glass substrate lamination device according to claim 4, wherein a base material for holding an electrode, of the electrostatic adsorption element, is a polyimide film.

6. A method for producing a laminated glass substrate by laminating two glass substrates of a thin glass substrate and a supporting glass substrate using the glass substrate lamination device according to any one of claims 1 to 5, said method comprising:
allowing the thin glass substrate adsorbed by the substrate adsorption unit possessed by the upper substrate supporting unit and the supporting glass substrate which has a resin layer on an upper surface thereof and is mounted on the lower substrate supporting unit to face each other;
decompressing inside of the space surrounded by the upper substrate supporting unit, the lower glass substrate supporting unit and the seal unit by the decompression unit; and thereafter,
allowing the thin glass substrate to contact with the supporting glass substrate, followed by pressurizing, thereby laminating said two glass substrates via the resin layer.

7. The method for producing a laminated glass substrate according to claim 6, wherein after allowing the thin glass substrate to contact with the supporting glass substrate, a compressed air is blown downwardly to an upper surface of the thin glass substrate by the compressed air supplying unit.

8. The method for producing a laminated glass substrate according to claim 6 or 7, wherein after allowing the thin glass substrate to contact with the supporting glass substrate, a pressurization treatment is carried out within a range of from 0.1 MPa to 1 MPa in the space surrounded by the upper substrate supporting unit, the lower substrate supporting unit and the seal unit or in a separate pressurization device.

9. The method for producing a laminated glass substrate according to any one of claims 6 to 8, wherein, when an upper surface area of the thin glass substrate is regarded as So, and a contact area of the substrate adsorption unit with the thin glass substrate as S₁, a relational expression 0.02 ≤S₁/S₀≤0.1 is satisfied.

10. The method for producing a laminated glass substrate according to any one of claims 6 to 9, wherein the substrate adsorption unit has an electrostatic adsorption element and the electrostatic adsorption element has an adsorbing strength for the thin glass substrate of 40 mN/cm² or more at an application voltage of 1 kV.

11. The method for producing a laminated glass substrate according to any one of claims 6 to 10, wherein the resin layer comprises at least one kind selected from the group consisting of an acrylic resin, a polyolefin resin, a polyurethane resin and a silicone resin.
